# EUROPEAN PATENT APPLICATION

(11) **EP 1 519 380 A1**
(43) Date of publication of application: **30.03.2005**
(21) Application number: 03730750.1
(22) Date of filing: 02.06.2003
(51) Int. Cl.: G11B 20/18, G11B 20/12, H03M 13/27

(54) **INTERLEAVED DATA ERROR CORRECTION METHOD AND DEVICE**

(71) Applicant: MATSUSHITA ELECTRIC INDUSTRIAL CO., LTD., Kadoma-shi, Osaka 571-8501 (JP)
(72) Inventor: MATSUDA, Syuji, Takatsuki-shi, Osaka 569-0081 (JP); NAKAMURA, Takashi, Neyagawa-shi, Osaka 572-0030 (JP)
(74) Representative: Holmes, Miles
(86) International application number: PCT/JP2003/006909
(87) International publication number: WO 2004/109694

(57) **Abstract**

In an error correction method for performing error correction on an error correction unit block in which main data are interleaved, after rearranging code lines in the order of error correction, it is judged whether the corresponding erasure position information indicates "erasure of data" or not with respect to only byte positions in a code line at a boundary between a main data area and a sub data area or a SY area, and erasure position information is set for only positions where erasure position information should be newly obtained. With respect to other byte positions, erasure position information at the same byte positions in a previous code line in the error correction order is set. However, when the previous code line is an error-incorrectable code line, erasure position information is set for all byte positions in a code line that is next to the incorrectable code line in the error correction order. With respect to the subsequent code lines, erasure position information is set until the target byte position reaches the next boundary between the main data area and the sub data area or the SY area. Thereby, the time required for error correction can be reduced.

## Description

### TECHNICAL FIELD

The present invention relates to an error correction method and an error correction apparatus and, more particularly, to an error correction method and an error correction apparatus for interleaved data.

### BACKGROUND ART

Conventionally, in a system performing recording/playback of digital data, since errors might occur in data during playback or recording, it is necessary to detect and correct the errors. Reed-Solomon codes are well known as error correcting codes to be used for such error correction.

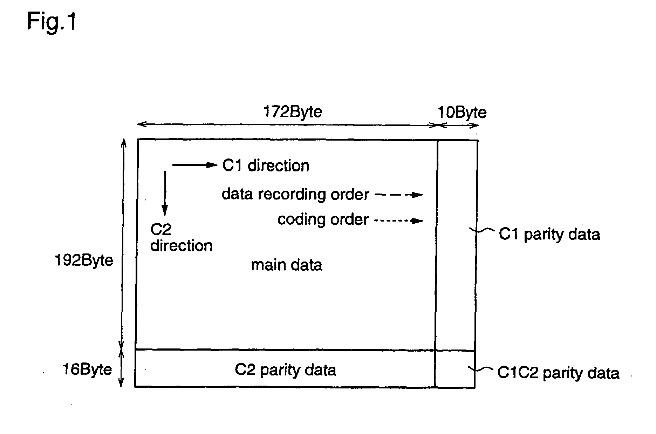

Hereinafter, a conventional error correction method will be described with reference to figure 1, taking as an example a case where data recorded on a DVD as an optical medium are subjected to error correction using Reed-Solomon codes. Figure 1 is a diagram indicating that data recorded on a DVD are divided into error correction unit blocks (ECC blocks).

Initially, Reed-Solomon-coded data are subjected to Reed-Solomon decoding, and error correction is carried out in a direction C1 or a direction C2 shown in figure 1. At this time, a position polynomial and a numeric value polynomial are generated from the Reed-Solomon-decoded data, and the roots thereof are obtained to obtain an error position and an error numeric value. When there exists an error exceeding the error correctability in each code line, the code line is regarded as an uncorrectable code line, and information relating to this uncorrectable code line is stored as erasure position information. When error correction for all code lines in one ECC block is completed with respect to one of the direction C1 and the direction C2, error correction is carried out in the other direction using the erasure position information. In this way, when the position of error data has previously been known, since the erasure position information indicating the position of error data can be utilized, only a numeric value polynomial should be generated when generating the above-mentioned polynomials. As a result, the error correctability can be enhanced. The above-mentioned conventional method utilizes that, in a DVD, the order in which the data are recorded and the order in which the code lines are arranged are in the same direction C1, and thereby all of settings of erasure position information are the same in one ECC block.

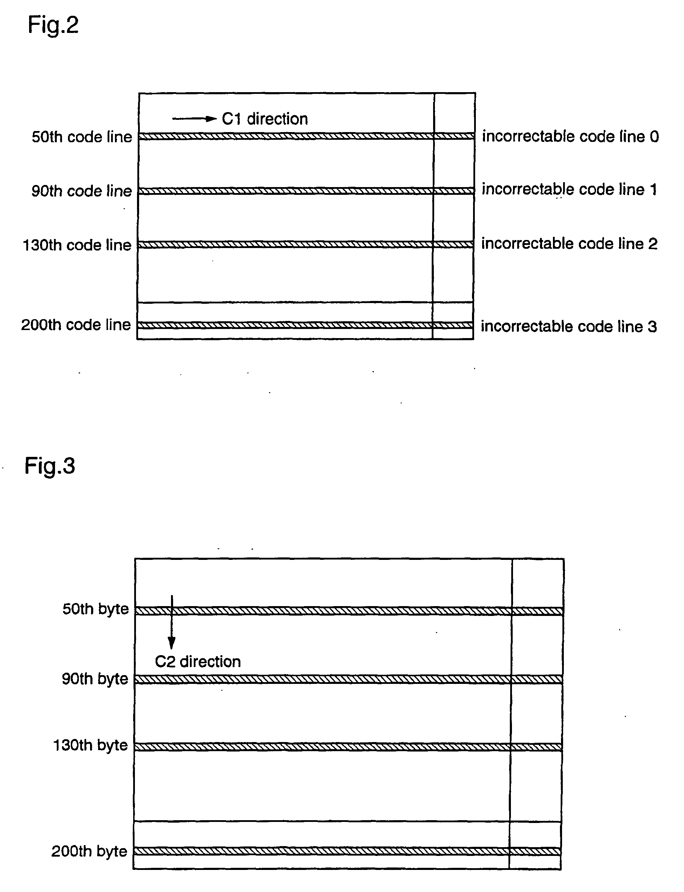

For example, it is assumed that initially error correction is carried out in the direction C1, and the 50th, 90th, 130th, and 200th code lines are uncorrectable code lines. In this case, as shown in figure 3, when performing error correction in the direction C2 that is the next error correction direction, the 50th, 90th, 130th, and 200th bytes are designated as erasure positions on the basis of the erasure position information indicating the previous uncorrectable code lines, thereby enhancing the error correctability in the direction C2.

However, if the recording order and coding order of the recorded data are the same like data recorded on a DVD, the error correctability to correct continuous data errors (burst errors) that occur due to contamination on the disc surface is degraded as the density of the recorded data is increased. Accordingly, in order to avoid such degradation in the error correctability due to large-scale burst errors that occur in the data, there has been proposed an error correction method in which data to be subjected to error correction is subjected to interleaving (P2002-521789A).

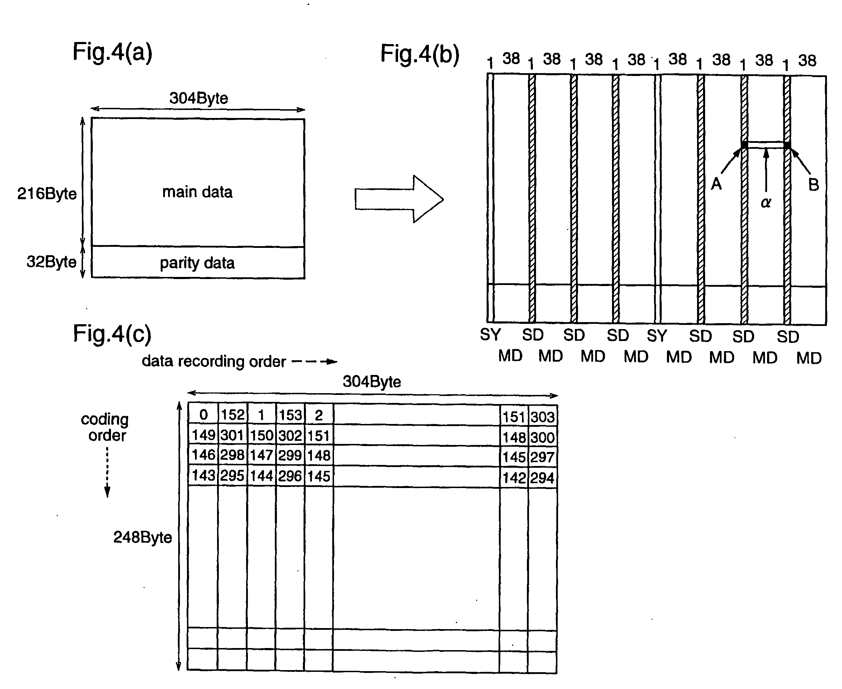

In this error correction method, under the state where the recording order and coding order for data in an ECC block are intersected, data to be subjected to error correction is divided into main data (MD) as recorded information and sub data (SD) to be used for calculating erasure position information of the main data, and the main data is subjected to interleaving. Figures 4(a) to 4(c) show an ECC block in a rewritable area of a high-density optical disc in which interleaved data are stored. As shown in figure 4(a), since a 32-byte parity data area is added to the ECC block, it is possible to set erasure position information up to 32 positions for every code line when performing error correction on the main data. In figure 4(b), "SY" indicates a code line in which position information to be used for SYNC detection is recorded. Further, the sizes of the main data and parity data shown in figures 4(a) to 4(c) are merely examples, and are not restricted thereto.

Hereinafter, an error correction processing for the ECC block shown in figure 4 will be described.

Initially, the sub data is subjected to error correction, and erasure position information of the main data is calculated on the basis of the result of the error correction. Then, the erasure position information is used when performing error correction on the main data. Thereby, the error correctability for the main data can be enhanced. The main data in the areas between the sub data or the areas between the SY and the sub data have the same erasure position information. For example, when errors exist in sub data A and sub data B shown in figure 4(b) and error correction is carried out, it is assumed that a burst error occurs in a main data area α sandwiched between the sub data A and B. When performing error correction on the main data, erasure position information calculated from the sub data A and B is set as erasure position information of the main data in the area α. In the ECC block shown in figure 4, since the main data is interleaved in the row direction (data recording order), setting of the erasure position information in the column direction (coding order) is different from that in the ECC block shown in figure 1, that is, the erasure positions are not the same in one ECC block. Accordingly, it is necessary to set erasure position information for every code line. For this purpose, 9,728 (32×304) times of erasure position information settings are required for once correcting the main data in the ECC block.

There has also been proposed an error correction apparatus for realizing the above-mentioned error correction method of performing error correction using previously known erasure position information. As examples of error correction apparatuses of this type, there have been proposed an apparatus in which a central processing unit (CPU) sets erasure position information on an error correction circuit (first error correction apparatus), and an apparatus in which an error correction circuit itself accesses a memory circuit in which erasure position information is stored, and obtains the erasure position information (second error correction apparatus).

However, the above-mentioned error correction apparatuses have the following drawbacks. First of all, in the first error correction apparatus, when performing error correction on interleaved data as shown in figure 4, 9,728 times of erasure position settings are required from the CPU to the error correction circuit. Therefore, the time required for error correction relative to the time required for the whole processing by the CPU is increased. As a result, when the error correction apparatus is constituted as an integrated circuit, the performance of the whole integrated circuit is significantly degraded.

On the other hand, in the second error correction apparatus, since the error correction circuit itself accesses the memory circuit in which the erasure position information has already been stored, to obtain the erasure position information, when performing error correction on interleaved data as shown in figure 4, 248 accesses per code line are made to obtain the erasure position information. That is, 75,392 times of accesses are made to perform error correction on all main data, and much time is spent for error correction.

As described above, the first and second error correction apparatuses take much time for error correction.

Therefore, the present invention has an object to achieve a reduction in time required for error correction in a method for performing error correction on interleaved data. Further, it is another object of the present invention to achieve a reduction in time required for error correction in an apparatus for performing error correction on interleaved data.

### DISCLOSURE OF THE INVENTION

According to Claim 1 of the present invention, an error correction method for performing error correction on data which are interleaved and are composed of plural code lines, comprises: a step of giving parameters for tracking down errors in the respective code lines; a rearrangement step of rearranging the code lines in the order in which error correction is to be carried out; a judgement step of, with a code line to be subjected to error correction being a target code line, comparing the parameter of the target code line that is given in the step of giving the parameters, with the parameter which is used when performing error correction on a code line that is previous to the target code line in the error correction order, and judging, according to the result of the comparison, as to which parameter is to be used for tracking down an error in the target block, the parameter in the target code line or the parameter which is used when performing error correction on the code line that is previous to the target code line in the error correction order; and an error correction step of performing error correction on the data for every code line, using the parameter.

According to the present invention, in the error correction method for performing error correction on the interleaved data using the parameters for tracking down errors, the time required for the data error correction can be reduced.

According to Claim 2 of the present invention, in the error correction method described in Claim 1, the parameter for tracking down an error in the target code line is determined before performing error correction on the target code line.

According to Claim 3 of the present invention, in the error correction method described in Claim 1, in the rearrangement step, the order of the code lines of the data are rearranged at intervals of at least two lines.

According to Claim 4 of the present invention, the error correction method described in Claim 1 further includes a first error correction incapability judgement step of judging whether or not the target code line is incapable of being subjected to error correction, on the basis of the parameter; wherein error correction is carried out without using the parameter when the result of the judgement in the first error correction incapability judgement step indicates "incapable of error correction".

According to Claim 5 of the present invention, the error correction method defined in Claim 4 further includes a second error correction incapability judgement step of judging whether or not a code line that is previous to the target code line in the error correction order was incapable of being subjected to error correction; wherein the target code line is subjected to error correction using the parameter of the target code line when the result of the judgement in the second error correction incapability judgement step indicates "incapable of error correction".

According to Claim 6 of the present invention, in the error correction method defined in Claim 1, the data are stored in an optical medium.

According to Claim 7 of the present invention, an error correction apparatus for performing error correction on data which are interleaved and are composed of plural code lines, comprises: a first memory circuit for storing data to be subjected to error correction; a first control circuit for performing control so as to rearrange data being transferred from the first memory circuit to the error correction circuit, in the order in which the data are to be subjected to error correction; an error correction circuit for performing error correction on the data stored in the first memory circuit, for each code line, using parameters for tracking down errors in the code lines; a storage unit for storing parameters that have been used for error correction by the error correction circuit; a comparator for comparing the parameter of the target code line with the parameter which has been used when performing error correction on a code line that is previous to the target code line in the error correction order and is stored in the storage unit; wherein the control circuit rearranges the order of the code lines to be subjected to error correction, at intervals of at least two lines, and the error correction circuit performs error correction on the target code line, according to the result of the comparison by the comparator, using, as the parameter for tracking down an error in the target code line, the parameter of the target code line or the parameter which has been used when performing error correction on a code line that is previous to the target code line in the error correction order.

According to the present invention, in the error correction apparatus for performing error correction on the interleaved data using the parameters for tracking down errors, the time required for the data error correction can be reduced.

According to Claim 8 of the present invention, an error correction apparatus defined in Claim 7 further includes a second memory circuit for storing the parameters, and a second control circuit for performing control so as to read the parameters from the second memory circuit, and transferring the parameters.

According to Claim 9 of the present invention, in the error correction apparatus defined in Claim 7, the storage unit is provided with a group of registers.

According to Claim 10 of the present invention, in the error correction apparatus defined in Claim 9, the group of registers hold the parameters which are obtained from the second memory circuit through the second control circuit.

According to Claim 11 of the present invention, in the error correction apparatus defined in Claim 10, the group of registers includes a first register for holding the number of parameters obtained from the second memory circuit; and a second register for holding the parameters obtained from the second memory circuit.

According to Claim 12 of the present invention, in the error correction apparatus defined in Claim 11, the second register is a shift register.

According to Claim 13 of the present invention, in the error correction apparatus defined in Claim 8, the second control circuit generates addresses to be used when reading the parameters from the second memory circuit on the basis of the information stored in the group of registers.

According to Claim 14 of the present invention, in the error correction apparatus defined in Claim 8, the data comparator compares the parameters stored in the second memory circuit with the parameters stored in the second register.

According to Claim 15 of the present invention, in the error correction apparatus defined in Claim 7, the first control circuit performs control such that at least two code lines of data to be subjected to error correction are simultaneously transferred from the first memory circuit to the error correction circuit; and the error correction circuit has a means capable of receiving at least two code lines of data simultaneously.

According to Claim 16 of the present invention, in the error correction apparatus defined in Claim 7, the data are stored in an optical medium.

### BRIEF DESCRIPTION OF THE DRAWINGS

Figure 1 is a diagram illustrating an example of construction of an ECC block on a DVD.
Figure 2 is a diagram illustrating an example of error correction with respect to C1 direction in the ECC block shown in figure 1.
Figure 3 is a diagram illustrating an example of error correction in C2 direction in the ECC block shown in figure 1.
Figures 4(a)-4(c) are diagrams illustrating an example of construction of an ECC block in a rewritable area on a high-density optical disc in which interleaved data are stored.
Figure 5 is a flowchart illustrating the procedure of error correction performed on main data in the ECC block shown in figure 4.
Figure 6 is a schematic diagram illustrating an example of construction of an error correction apparatus according to a first embodiment of the present invention.
Figure 7 is a schematic diagram illustrating the order in which main data are transferred in the error correction apparatus shown in figure 6.
Figure 8 is a schematic diagram illustrating the order in which main data are subjected to error correction in the error correction apparatus shown in figure 6.

### BEST MODE TO EXECUTE THE INVENTION

### (Embodiment 1)

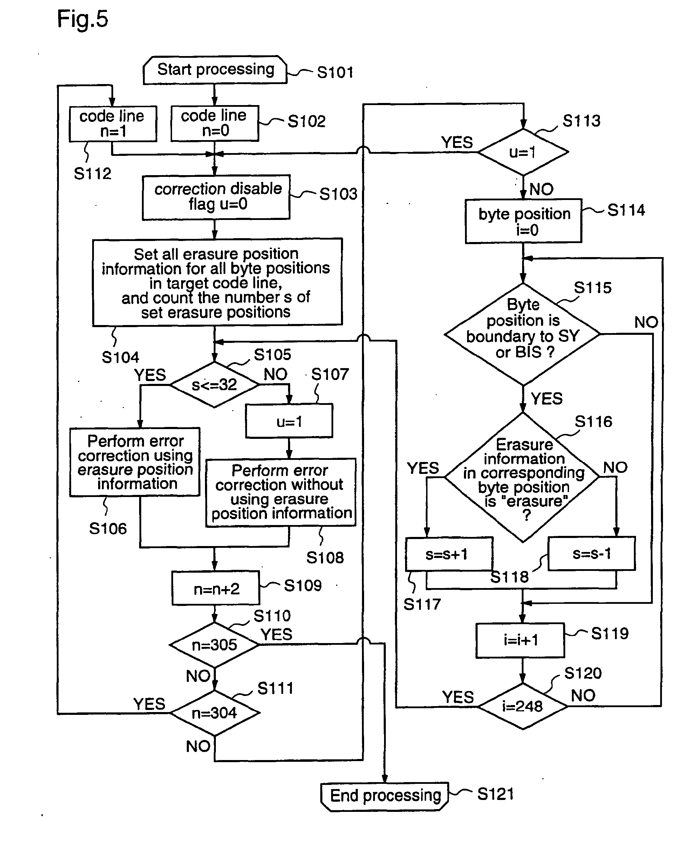

A first embodiment of the present invention will be described with reference to figures 5 to 8. An error correction method according to the first embodiment is a method for performing error correction on interleaved data in an ECC block, as shown in figure 4. Therefore, initially error correction is performed on sub data, and erasure position information of main data is calculated on the basis of the result of error correction, and the information is used when performing error correction on the main data, as described for the conventional example. That is, the erasure position information is a parameter for tracking down an error in each code line of the main data. When the data in the ECC block has been subjected to Reed-Solomon coding, error position information is obtained from a position polynomial that is calculated at Reed-Solomon decoding, and the error position information is calculated by using a specific algorithm to obtain erasure position information.

Hereinafter, the procedure of main data error correction will be described in detail using a flowchart shown in figure 5. Initially, erasure position information about all byte positions in a code line 0 is set, and the number of erased data S in the code line 0 is counted (step S104). Before performing step S104, an error correction incapability flag indicating whether the code line is incapable of being subjected to error correction or not is initialized (step S103). When the number of erased data S counted in step S104 is equal to or smaller than 32, error correction is carried out using the erasure position information (step S106). On the other hand, when the number of erased data S is equal to or larger than 33, the error correction incapability flag is incremented from 0 to 1 (step S107), and error correction is carried out without using the erasure position information (step S108). The reason is as follows. As shown in figure 4, since, in the ECC block, the parity data area has 32 bytes, error correction can be carried out using the erasure position information when the number of erased data S is equal to or smaller than 32, but error correction cannot be carried out using the erasure position information when the number of erased data S is equal to or larger than 33. Next, the number of code lines on which error correction has been completed is incremented by 2 (step S109). That is, since interleaving has been done so that every other code line should be subjected to error correction, the code lines are rearranged in the error correction order. That is, after performing error correction on the code line 0, even-numbered code lines (code lines 2, 4, 6, 8, ..., 308) are subjected to error correction, and thereafter, odd-numbered code lines (code lines 1, 3, 7, 9, ..., 303) are subjected to error correction. When the code lines are rearranged in the error correction order, the code line 1 becomes the 152nd code line. Since, in this embodiment, error correction is performed on the ECC block shown in figure 4, the number of code lines is incremented by 2 in step S109. However, the number of code lines to be incremented depends on how many code lines have been skipped when the code lines to be subjected to error correction are arranged in the error correction order. For example, when every third code lines are to be subjected to error correction, the number of code lines is incremented by 3 in step S109. After step S109, if the number of code lines incremented is 305 (n = 305), it is judged that setting of erasure position information is done for all of the code lines (step S110). On the other hand, when the number of code lines incremented is not 305, it is judged whether setting of erasure position information for the even-numbered code lines has been completed or not (step S111). When the result of the judgement in step S111 is "yes", setting of erasure position information for all byte positions in the code line 1 is started. On the other hand, when the result of the judgement in step S111 is "No", it is judged as to whether the previously error-corrected code line was incapable of being subjected to error correction or not (step S113). In this first embodiment, when the immediately previous code line (i.e., the code line 0 when the result of increment in step S109 is n = 2) is judged as to whether it is an error-incorrectable code line or not. When the result of the judgement in step S113 is "Yes", steps S103 to S108 are repeated to set erasure position information for the target code line and, further, the number of erased data is counted. On the other hand, when the result of the judgement in step S113 is "No", all of the byte positions in the target code line are subjected to judgement as to whether the byte positions are boundaries with the sub data area or the SY area (step S115), starting from the byte position i = 0 (step S114). The reason is as follows. Since the main data between sub data or the main data between sub data and SY have the same erasure position information, erasure position information should be set at only the boundary between the main data area and the sub data area or the SY area. To be specific, when the code lines are rearranged in the error correction order, the byte positions of the code line 0, code line 38, code line 76, code line 114, code line 152, code line 190, code line 228, and code line 266 are boundaries with the sub data area or the SY area. When the result of the judgement in step S115 is "No", since the erasure position information at the same byte position in the previous code line is used, the processing goes to step S119 to judge whether the next byte position is a boundary with the sub data area or the SY area. On the other hand, when the result of the judgement in step S115 is "Yes", i.e., when the byte position is a boundary with the sub data area, it is judged whether the erasure position information in the target byte position in the target code line indicates "erasure" or not (step S116). When the result of the judgement in step S116 indicates "erasure", the number of erased data is incremented (step S117). When it does not indicate "erasure", the number of erased data is decremented (step S118). The operations of the above-mentioned steps S115 to S118 are repeated up to the final byte in one code line (i = 248) (step S119). When erasure information setting is completed up to the final byte in the one code line (step S120), the processing goes to step S105 to execute error correction.

As described above, in the error correction method according to the first embodiment, as for the code line 0 and the code line 1 in the ECC block, the corresponding erasure position information is set for all of the byte positions. Then, the code lines are rearranged in the error correction order, and it is judged whether the corresponding erasure position information indicates "erasure of data" or not, for all of the byte positions at the boundary between the main data area and the sub data area or the SY area in the code line. Then, erasure position information is set for only positions where erasure position information should be newly obtained. As for the other byte positions, erasure position information of the previous code line at the same byte position in the error correction order is set. However, when the previous code line is an error-incorrectable code line, erasure position information is set for all of the byte positions in the next code line that is next to the error incorrectable code line in the error correction order. As for the subsequent code lines, erasure position information thereof is set again until the target byte position reaches the boundary position between the main data area and the sub data area or the SY area. Thereby, the number of settings of erasure position information is reduced as compared with the case where erasure position information should be set for all positions in all code lines, resulting in a reduction in the time required for error correction.

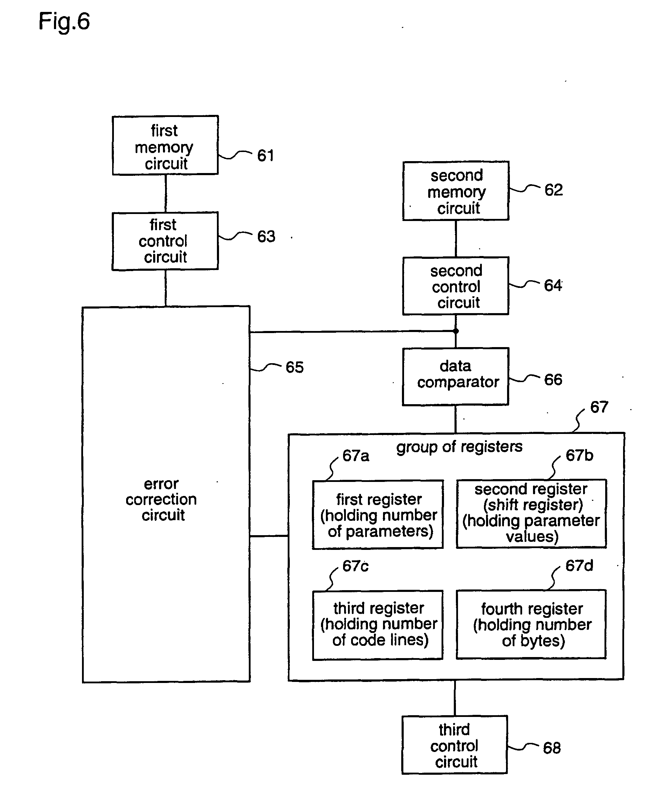

Hereinafter, an error correction apparatus that realizes the above-mentioned error correction method will be described with reference to figures 6 to 8. Figure 6 is a block diagram illustrating an example of construction of an error correction apparatus. As shown in figure 6, the error correction apparatus comprises a first memory circuit 61, a second memory circuit 62, a first control circuit 63, a second control circuit 64, an error correction circuit 65, a data comparator 66, a register unit 67, and a third control circuit 68. The register unit 67 comprises a first register 67a, a second register 67b, a third register 67c, and a fourth register 67d. The first memory circuit 61 stores data to be subjected to error correction. The first control circuit 63 controls data transfer from the first memory circuit 61 to the error correction circuit 65. The error correction circuit 65 performs error correction for data transferred from the first control circuit 63. The error correction circuit 65 is provided with a reception means (not shown) for receiving two or more code lines of data. For example, it is provided with, as the reception means, a holding circuit for holding two or more code lines of data. The second memory circuit 62 stores information relating to error correction. In this first embodiment, it stores erasure position information. The second control circuit 64 controls transfer of information from the second memory circuit 62 to the register unit 67. The first register 67a holds the number of information (parameter values) obtained from the second memory circuit 64. Since the parameter values indicate the erasure position information, the number of parameter values is the number of erasure position information. The second register 67b is a shift register, and holds the erasure position information obtained from the second memory circuit 62, as parameter values. The data comparator 66 compares the parameter values stored in the second register 67b with the parameter values transferred from the second memory circuit 62. Since a shift register is used as the second register 67b, it is not necessary to provide a data comparator 66 for every parameter value, and comparison can be carried out for every parameter value shifted, resulting in a reduction in the circuit scale of the error correction apparatus. The third register 67c holds the number of code lines counted by the third control circuit 68. The fourth register 67d holds the number of bytes counted by the third control circuit 68.

Further, the respective circuits mentioned above are connected to each other via an internal bus. The internal bus comprises an address bus, a data bus, and control buses such as a read strobe, write strobe, and a reset signal.

Hereinafter, a description will be given of the operation of the error correction apparatus constructed as described above, when performing error correction for the ECC block shown in figure 4.

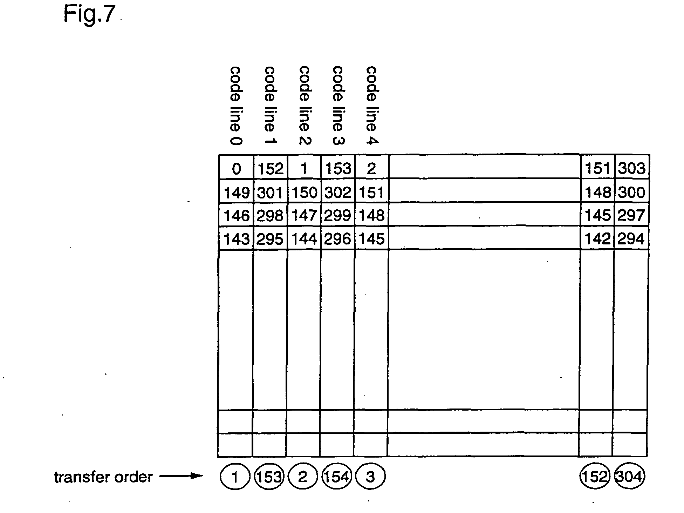

First of all, the data stored in the first memory circuit 61 is transferred to the error correction circuit 65 under control of the first control circuit 63. Figure 7 shows an example of setting of the order in which data are transferred to the error correction circuit 65. As shown in figure 7, the data transfer order is set not for every code line (0th code line, 1st code line, 2nd code line, ..., 303rd code line) but for every other code line (0th code line, 2nd code line, 4th code line, 302nd code line, 1st code line, 3rd code line, ..., 303rd code line). This is because, in the ECC block shown in figure 4, the data have been interleaved so that every two code lines are skipped with respect to the coding order. That is, the first control circuit 63 rearranges the code lines at intervals of two or more lines.

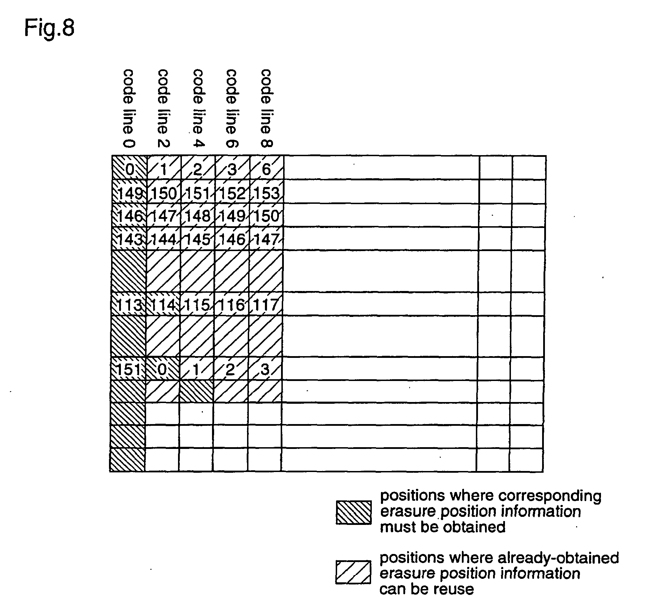

The error correction circuit 65 performs error correction in the order in which the data are to be transferred through the first control circuit 63. Hereinafter, the error correction processing will be described with reference to figure 8. Figure 8 shows an image of the order in which the main data are subjected to error correction. Initially, error correction is performed on the sub data, and then erasure position information of the main data is calculated on the basis of the result of the error correction. The erasure position information is stored in the second memory circuit 62. After the error correction for the sub data, initially the code line 0 of the main data is transferred from the first memory circuit 61 through the first control circuit 63 to the error correction circuit 65. On receipt of the code line 0, the error correction circuit 65 obtains all of 248 bytes of erasure position information corresponding to the code line 0 from the second memory circuit 62 through the second control circuit 64. Then, the error correction circuit 65 performs error correction starting from the code line 0. At this time, the third control circuit 68 counts the number of erased data on the basis of the erasure position information. The result of the count is stored in the first register 67a. When the number of erased data does not exceed 32, error correction is carried out using the erasure position information. The erasure position information used by the error correction circuit 65 is stored in the register 67b. On the other hand, when the number of erased data exceeds 32, it is judged that error correction is impossible, and error correction is carried out without using the erasure position information. The erasure position information that is set at error correction is held by the second register 67b.

Next, in contrast to the order in which the code lines are actually stored in the recording disc, the first control circuit 63 transfers the code line 2 to the error correction circuit 65, i.e., one code line is skipped. The error correction circuit 65 performs error correction on the code line 2 by reusing the erasure position information that is stored in the second register 67b at error correction for the code line 0. This is because, as shown in figure 4(b), the 0th to 37th code lines have the same erasure position information. However, when the target code line is at the boundary between the main data area and the sub data area or the SY area, the already-obtained erasure position information cannot be reused, and therefore, erasure position information corresponding to the target code line is newly obtained from the second memory circuit 62 through the second control circuit 64 to perform error correction. By the way, addresses required for reading the erasure position information are generated by the second control circuit 64 on the basis of the information stored in the register unit 67. In the ECC block shown in figure 4, when the code lines are rearranged in the error correction order, the 38th code line, the 76th code line, the 114th code line, the 152nd code line, the 190th code line, the 228th code line, and the 266th code line are code lines at the boundary. The third control circuit 68 judges whether the target code line is a code line at the boundary or not. Further, when the number erased data positions in the code line previous to the target code line exceeds 32, erasure position information is newly obtained for the next code line (target code line) in the error correction order, from the second memory circuit 62 through the second control circuit 64.

The data comparator 66 compares the parameter values stored in the second memory circuit 62 with the parameter values held by the second register 67b, with respect to all of the byte positions in the code line to be read from the second memory circuit 64, i.e., the positions where the erasure position information shown in figure 8 must be obtained. The number of bytes compared is counted by the third control circuit 68, and the result of the count is held by the fourth register 67d. Further, the number of erased data obtained from the erasure position information is also counted by the third control circuit 68, and the result of the count is held by the first register 67a. On the basis of the result of the comparison, the third control circuit 68 judges that it is not necessary to read the erasure position information which is already held by the second register 67b, from the second memory circuit 62, and the error correction circuit 65 performs error correction using the erasure position information held by the second register 67b.

As described above, the error correction apparatus according to the first embodiment reads all of erasure position information corresponding to the code lines 0 and 1 in the ECC block, from the second memory circuit 62. Then, the code lines are rearranged in the error correction order, and thereafter, the erasure position information stored in the second memory circuit 62 is compared with the erasure position information stored in the second register 67b, with respect to all of the byte positions in the code line at the boundary between the main data area and the sub data area or the SY area, and the second memory circuit 62 is accessed to obtain erasure position information for only byte positions where erasure position information should be newly obtained. However, when the code line previous to the target code line is an error-incorrectable code line, erasure position information corresponding to the next code line (target code line) in the error correction order is read from the memory circuit 62. Thereby, the number of settings of erasure position information is reduced as compared with the case where erasure position information is set for all positions in all code lines, resulting in a reduction in time required for error correction.

While the error correction apparatus shown in figure 6 includes two memory circuits, three control circuits, and two registers, the numbers of these circuits are not restricted thereto. For example, the error correction apparatus may be provided with one or more than two memory circuits, control circuits, and registers.

While in this first embodiment the second register 67 shown in figure 6 is a shift register, the present invention is not restricted thereto.

### APPLICABILITY IN INDUSTRY

The present invention is suitable for a high-density optical disc recording/reproduction apparatus that records or reproduces interleaved data.

## Claims

1. An error correction method for performing error correction on data which are interleaved and are composed of plural code lines, said method comprising:
a step of giving parameters for tracking down errors in the respective code lines;
a rearrangement step of rearranging the code lines in the order in which error correction is to be carried out;
a judgement step of, with a code line to be subjected to error correction being a target code line, comparing the parameter of the target code line that is given in the step of giving the parameters, with the parameter which is used when performing error correction on a code line that is previous to the target code line in the error correction order, and judging, according to the result of the comparison, as to which parameter is to be used for tracking down an error in the target block, the parameter in the target code line or the parameter which is used when performing error correction on the code line that is previous to the target code line in the error correction order; and
an error correction step of performing error correction on the data for every code line, using the parameter.

2. An error correction method as defined in Claim 1 wherein the parameter for tracking down an error in the target code line is determined before performing error correction on the target code line.

3. An error correction method as defined in Claim 1 wherein, in said rearrangement step, the order of the code lines of the data are rearranged at intervals of at least two lines.

4. An error correction method as defined in Claim 1 further including a first error correction incapability judgement step of judging whether or not the target code line is incapable of being subjected to error correction, on the basis of the parameter;
wherein error correction is carried out without using the parameter when the result of the judgement in the first error correction incapability judgement step indicates "incapable of error correction".

5. An error correction method as defined in Claim 4 further including a second error correction incapability judgement step of judging whether or not a code line that is previous to the target code line in the error correction order was incapable of being subjected to error correction;
wherein the target code line is subjected to error correction using the parameter of the target code line when the result of the judgement in the second error correction incapability judgement step indicates "incapable of error correction".

6. An error correction method as defined in Claim 1 wherein said data are stored in an optical medium.

7. An error correction apparatus for performing error correction on data which are interleaved and are composed of plural code lines, said apparatus comprising:
a first memory circuit for storing data to be subjected to error correction;
a first control circuit for performing control so as to rearrange data being transferred from the first memory circuit to the error correction circuit, in the order in which the data are to be subjected to error correction;
an error correction circuit for performing error correction on the data stored in the first memory circuit, for each code line, using parameters for tracking down errors in the code lines;
a storage unit for storing parameters that have been used for error correction by the error correction circuit;
a comparator for comparing the parameter of the target code line with the parameter which has been used when performing error correction on a code line that is previous to the target code line in the error correction order and is stored in the storage unit;
wherein said control circuit rearranges the order of the code lines to be subjected to error correction, at intervals of at least two lines; and
said error correction circuit performs error correction on the target code line, according to the result of the comparison by the comparator, using, as the parameter for tracking down an error in the target code line, the parameter of the target code line or the parameter which has been used when performing error correction on a code line that is previous to the target code line in the error correction order.

8. An error correction apparatus as defined in Claim 7 further including:
a second memory circuit for storing the parameters; and
a second control circuit for performing control so as to read the parameters from the second memory circuit, and transferring the parameters.

9. An error correction apparatus as defined in Claim 7 wherein said storage unit is provided with a group of registers.

10. An error correction apparatus as defined in Claim 9 wherein said group of registers hold the parameters which are obtained from the second memory circuit through the second control circuit.

11. An error correction apparatus as defined in Claim 10 wherein said group of registers includes:
a first register for holding the number of parameters obtained from the second memory circuit; and
a second register for holding the parameters obtained from the second memory circuit.

12. An error correction apparatus as defined in Claim 11 wherein said second register is a shift register.

13. An error correction apparatus as defined in Claim 8 wherein said second control circuit generates addresses to be used when reading the parameters from the second memory circuit on the basis of the information stored in the group of registers.

14. An error correction apparatus as defined in Claim 8 wherein said data comparator compares the parameters stored in the second memory circuit with the parameters stored in the second register.

15. An error correction apparatus as defined in Claim 7 wherein
said first control circuit performs control such that at least two code lines of data to be subjected to error correction are simultaneously transferred from the first memory circuit to the error correction circuit; and
said error correction circuit has a means capable of receiving at least two code lines of data simultaneously.

16. An error correction apparatus as defined in Claim 7 wherein said data are stored in an optical medium.
